# EUROPEAN PATENT APPLICATION

(11) **EP 4 679 987 A1**
(43) Date of publication of application: **14.01.2026**
(21) Application number: 25187954.0
(22) Date of filing: 07.07.2025
(51) Int. Cl.: H10K 59/12, H10K 59/122, H10K 59/124, H10K 59/35, H10K 59/80, H10K 59/123

(54) **DISPLAY PANEL, ELECTRONIC APPARATUS INCLUDING THE DISPLAY PANEL, AND METHOD FOR MANUFACTURING THE DISPLAY PANEL**

(30) Priority: 12.07.2024 KR 20240092375
(71) Applicant: Samsung Display Co., Ltd., Yongin-si, Gyeonggi-do 17113 (KR)
(72) Inventor: PARK, Joonyong, 17113 Yongin-si (KR); SHIN, Hyuneok, 17113 Yongin-si (KR); YANG, Sukyoung, 17113 Yongin-si (KR); LEE, Dongmin, 17113 Yongin-si (KR)
(74) Representative: Marks & Clerk LLP

(57) **Abstract**

A display panel includes a substrate, a transistor, an insulating layer, a first light-emitting diode, a second light-emitting diode, and a first encapsulation layer. The transistor is disposed on the substrate. The insulating layer is disposed on the transistor and includes an opening. The first light-emitting diode and the second light-emitting diode are disposed adjacent to each other on the insulating layer. The first encapsulation layer is disposed on the first light-emitting diode and the second light-emitting diode. Each of the first light-emitting diode and the second light-emitting diode includes: a first electrode disposed on the insulating layer, with an edge portion overlapping the opening; a light-emitting layer disposed on the first electrode; and a second electrode disposed on the light-emitting layer. The second electrode of the first light-emitting diode is spaced apart from the second electrode of the second light-emitting diode by the first encapsulation layer.

## Description

### BACKGROUND

### 1. Field

The present disclosure relates to a display panel, and more specifically, to a display panel in which a separate light-emitting layer is formed for each light-emitting region without a mask, an electronic apparatus including the display panel, and a method for manufacturing the display panel.

### 2. Description of the Related Art

Electronic devices such as, for example, smartphones, digital cameras, laptop computers, navigation systems, and smart televisions, which provide images to users, include display devices. A display device generates an image and provides the generated image to the user through a display screen.

Various types of display panels, such as, for example, liquid crystal display panels (LCD panels) and organic light-emitting display panels (OLED panels), have been developed as display panels for display devices. Among them, the organic light-emitting display panel includes light-emitting diodes that can emit light by themselves. Each of the light-emitting diodes includes an anode, a cathode, and a light-emitting layer. The light-emitting layer is formed separately for each light-emitting region.

Recently, display panels have also been applied to goggle-type electronic devices for providing virtual reality or augmented reality. In such cases, the display panel may be manufactured in a very small size and have a high pixel density to achieve high resolution. As a result, the area of each light-emitting region is small, making it challenging to form a separate light-emitting layer for each light-emitting region using a mask process.

### SUMMARY

An embodiment of the present disclosure provides a display panel capable of forming a separate light-emitting layer for each light-emitting region without a mask, thereby improving display quality, as well as an electronic apparatus including such a display panel and a method for manufacturing the display panel.

A display panel includes, a substrate, a transistor, an insulating layer, a first light-emitting diode, a second light-emitting diode, and a first encapsulation layer. The transistor is disposed on the substrate. The insulating layer is disposed on the transistor, and the insulating layer includes an opening. The first light-emitting diode and the second light-emitting diode are disposed adjacent to each other on the insulating layer. The first encapsulation layer is disposed on the first light-emitting diode and the second light-emitting diode. Each of the first light-emitting diode and the second light-emitting diode includes: a first electrode disposed on the insulating layer and having an edge portion overlapping with the opening in a planar view; a light-emitting layer disposed on the first electrode; and a second electrode disposed on the light-emitting layer. The second electrode of the first light-emitting diode is spaced apart from the second electrode of the second light-emitting diode by the first encapsulation layer in the region which overlaps with the opening in a planar view.

According to an embodiment of the present disclosure, a side surface of the second electrode of the first light-emitting diode and a side surface of the second electrode of the second light-emitting diode may be disposed in a region overlapping with the opening in the planar view. The first encapsulation layer may cover the side surface of the second electrode of the first light-emitting diode and the side surface of the second electrode of the second light-emitting diode in a cross-sectional view.

According to an embodiment of the present disclosure, the first encapsulation layer may have an integral shape, including a first portion overlapping with the second electrode of the first light-emitting diode in the planar view and disposed on the second electrode of the first light-emitting diode, a second portion overlapping with the second electrode of the second light-emitting diode in the planar view and disposed on the second electrode of the second light-emitting diode, and a third portion connecting the first and second portions in the region overlapping with the opening in the planar view. The third portion may include a first sub-portion that overlaps with the second electrode of the first light-emitting diode in the planar view and is disposed beneath the second electrode of the first light-emitting diode, a second sub-portion that overlaps with the second electrode of the second light-emitting diode in the planar view and is disposed beneath the second electrode of the second light-emitting diode, and a third sub-portion that is disposed between the second electrode of the first light-emitting diode and the second electrode of the second light-emitting diode in the planar view, thereby connecting the first portion, the second portion, the first sub-portion, and the second sub-portion.

According to an embodiment of the present disclosure, an upper surface of the third sub-portion may be positioned higher than both the second electrode of the first light-emitting diode and the second electrode of the second light-emitting diode across an entire region between the second electrode of the first light-emitting diode and the second electrode of the second light-emitting diode in a cross-sectional view.

According to an embodiment of the present disclosure, the first encapsulation layer may include an inorganic material, and a cavity, which is a sealed space defined by the first encapsulation layer, may be between the upper surface and a lower surface of the third sub-portion.

According to an embodiment of the present disclosure, the display panel may further include a common electrode disposed on the first encapsulation layer and a second encapsulation layer disposed on the common electrode. The first encapsulation layer may include second contact holes respectively exposing a portion of an upper surface of the second electrode of the first light-emitting diode and a portion of an upper surface of the second electrode of the second light-emitting diode. The common electrode may be respectively connected to the second electrode of the first light-emitting diode and the second electrode of the second light-emitting diode through the second contact holes.

According to an embodiment of the present disclosure, the second contact holes may include a first sub-contact hole that exposes a portion of an upper surface of the second electrode of the first light-emitting diode and a second sub-contact hole that exposes a portion of an upper surface of the second electrode of the second light-emitting diode. The common electrode may be connected to the second electrode of the first light-emitting diode through the first sub-contact hole. The common electrode may be connected to the second electrode of the second light-emitting diode through the second sub-contact hole. The common electrode may have an integral shape and connect the second electrode of the first light-emitting diode and the second electrode of the second light-emitting diode together.

According to an embodiment of the present disclosure, the second encapsulation layer may include: a fourth sub-encapsulation layer disposed on the common electrode and including an organic material; and a fifth sub-encapsulation layer disposed on the fourth sub-encapsulation layer and including an inorganic material.

According to an embodiment of the present disclosure, the second electrode of the first light-emitting diode may include a cathode electrode disposed on the light-emitting layer of the first light-emitting diode and a protective electrode disposed on the cathode electrode. The second electrode of the second light-emitting diode may include a cathode electrode disposed on the light-emitting layer of the second light-emitting diode and a protective electrode disposed on the cathode electrode.

According to an embodiment of the present disclosure, the display panel may further include a pixel defining layer that surrounds an upper surface, a side surface, and a lower surface of an edge portion of the first electrode of the first light-emitting diode, as well as an upper surface, a side surface, and a lower surface of an edge portion of the first electrode of the second light-emitting diode. The pixel defining layer may extend along a side surface and a bottom surface of the opening, have an integral shape, and include an inorganic material.

The pixel defining layer may include: a first lower portion disposed between the lower surface of the edge portion of the first electrode of the first light-emitting diode and an upper surface of the first sub-portion of the first encapsulation layer; a first side portion disposed between a side surface of the insulating layer defining the opening and a side surface of the first sub-portion of the first encapsulation layer; a second lower portion disposed between the lower surface of the edge portion of the first electrode of the second light-emitting diode and an upper surface of the second sub-portion of the first encapsulation layer; a second side portion disposed between a side surface of the insulating layer defining the opening and a side surface of the second sub-portion of the first encapsulation layer; and a bottom portion disposed between the bottom surface of the opening and a lower surface of the third portion of the first encapsulation layer.

According to an embodiment of the present disclosure, the insulating layer may include a first contact hole. The first electrode of the light-emitting diode may be connected to the transistor through the first contact hole. The first electrode, the light-emitting layer, and the second electrode of the first light-emitting diode may each cover the first contact hole in a planar view. The display panel may further include a short-circuit prevention layer disposed between the first electrode and the light-emitting layer of the first light-emitting diode and covering the first contact hole in a planar view.

According to an embodiment of the present disclosure, the first electrode of the first light-emitting diode may include a first protrusion extending downward toward the transistor in a region overlapping with the first contact hole in the planar view. The short-circuit prevention layer may include a second protrusion extending downward toward the transistor in a region overlapping with the first contact hole in the planar view and disposed within the first protrusion. The light-emitting layer of the first light-emitting diode may include a third protrusion extending downward toward the transistor in a region overlapping with the first contact hole in the planar view and disposed within the second protrusion. The second electrode of the first light-emitting diode may include a fourth protrusion extending downward toward the transistor in a region overlapping with the first contact hole in the planar view and disposed within the third protrusion.

According to an embodiment of the present disclosure, the short-circuit prevention layer may be formed of the same material as the pixel defining layer.

According to an embodiment of the present disclosure, the first electrode of the first light-emitting diode may include a metal layer disposed on the insulating layer and an anode electrode disposed between the metal layer and the light-emitting layer of the first light-emitting diode.

According to an embodiment of the present disclosure, the light-emitting layer of the first light-emitting diode may cover the first electrode of the light-emitting diode in the planar view, and at least a portion of the light-emitting layer of the first light-emitting diode may be disposed on the side surface of the first electrode of the first light-emitting diode.

According to an embodiment of the present disclosure, the second electrode of the first light-emitting diode may cover the light-emitting layer of the first light-emitting diode in the planar view, and at least a portion of the second electrode of the first light-emitting diode may be disposed on a side surface of the light-emitting layer of the first light-emitting diode.

A display panel according to another aspect of the present disclosure may include: a substrate; a transistor disposed on the substrate; an insulating layer disposed on the transistor and provided with an opening; a light-emitting diode disposed on the insulating layer; and a first encapsulation layer disposed on the light-emitting diode. The light-emitting diode may include: a first electrode disposed on the insulating layer and having an edge portion overlapping with the opening in a planar view; a light-emitting layer disposed on the first electrode; and a second electrode disposed on the light-emitting layer. The insulating layer may be provided with a first contact hole, and the first electrode may be connected to the transistor through the first contact hole. The first electrode, the light-emitting layer, and the second electrode may each cover the first contact hole in the planar view, and a short-circuit prevention layer may be disposed between the first electrode and the light-emitting layer, covering the first contact hole in the planar view.

Yet another aspect of the present disclosure may provide an electronic apparatus, which includes: a substrate; a transistor disposed on the substrate; an insulating layer disposed on the transistor and provided with an opening; a first light-emitting diode and a second light-emitting diode disposed adjacent to each other on the insulating layer; and a first encapsulation layer disposed on the first light-emitting diode and the second light-emitting diode. Each of the first light-emitting diode and the second light-emitting diode may include: a first electrode disposed on the insulating layer and having an edge portion overlapping with the opening in a planar view; a light-emitting layer disposed on the first electrode; and a second electrode disposed on the light-emitting layer. The second electrode of the first light-emitting diode may be spaced apart from the second electrode of the second light-emitting diode by the first encapsulation layer in a region which overlaps with the opening in the planar view.

According to an embodiment of the present disclosure, the electronic apparatus may be one of a flat panel display, a curved display, a television, a billboard, a computer monitor, a medical monitor, a head-mounted display (HMD), an indoor or outdoor lighting or signal light, a wearable device, a foldable device, a rollable device, a bendable device, a flexible device, a curved device, an electronic notebook, an e-book, a portable multimedia player (PMP), a personal digital assistant (PDA), a laser printer, a telephone, a mobile phone, a tablet PC, a portable terminal, a notebook, a laptop computer, a digital camera, a viewfinder, a camcorder, a 3D display, a virtual reality or augmented reality display, a video wall including tiled multiple displays, a vehicle, an outdoor display device, a theater or stadium screen, and a signboard.

Still another aspect of the present disclosure may provide a method for manufacturing a display panel, the method including: forming a transistor on a substrate; forming an insulating layer on the transistor; forming a first preliminary electrode on the insulating layer; forming first electrodes by etching the first preliminary electrode; forming an opening in the insulating layer by etching the insulating layer through a gap formed between the first electrodes, the opening having a width larger than the gap; forming a plurality of first light-emitting diodes by sequentially forming a first preliminary light-emitting layer, a first preliminary sub-electrode, and a first preliminary encapsulation layer on the insulating layer; covering, from among the plurality of first light-emitting diodes, the first light-emitting diodes corresponding to a first light-emitting region with a photomask and etching the first preliminary light-emitting layer, the first preliminary sub-electrode, and the first preliminary encapsulation layer; forming a plurality of second light-emitting diodes by sequentially forming a second preliminary light-emitting layer, a second preliminary sub-electrode, and a second preliminary encapsulation layer on the insulating layer; covering, from among the plurality of second light-emitting diodes, the second light-emitting diodes corresponding to a second light-emitting region with a photomask and etching the second preliminary light-emitting layer, the second preliminary sub-electrode, and the second preliminary encapsulation layer; and forming a first encapsulation layer in a region overlapping with the opening in a planar view, wherein second electrodes of the first light-emitting diodes corresponding to the first light-emitting region are spaced apart from second electrodes of the second light-emitting diodes corresponding to the second light-emitting region by the first encapsulation layer.

According to an embodiment of the present disclosure, by having an undercut shape provided by the insulating layer and the first electrode disposed on the insulating layer, it is possible to form the light-emitting layer to be separate on the first electrode without a mask.

Moreover, as the light-emitting layer is formed on the insulating layer rather than inside the opening, shadow regions can be prevented during the deposition process, thereby improving display quality.

At least some of the above and other features of the invention are set out in the claims.

### BRIEF DESCRIPTION OF THE DRAWINGS

These and/or other features will become apparent and more readily appreciated from the following description of the embodiments, taken in conjunction with the accompanying drawings in which:
FIG. 1 is a plan view illustrating a display panel according to an embodiment of the present disclosure;
FIG. 2 is a cross-sectional view taken along line I-I of FIG. 1;
FIG. 3 is an enlarged view of a portion of FIG. 2;
FIG. 4 is an enlarged view of a portion including the pixel defining layer in FIG. 3;
FIG. 5 is an enlarged view of a portion including the short-circuit prevention layer in FIG. 3;
FIG. 6 illustrates only the insulating layer and the first electrode of the display element layer illustrated in FIG. 3;
FIG. 7 is a flowchart illustrating a method for manufacturing a display panel according to an embodiment of the present disclosure;
FIGS. 8 to 19 illustrate each step of the method for manufacturing the display panel illustrated in FIG. 7;
FIG. 20 illustrates a modified example of the display panel described with reference to FIGS. 1 to 6;
FIG. 21 illustrates another modified example of the display panel described with reference to FIGS. 1 to 6; and
FIGS. 22 and 23 illustrate electronic devices including the display panel according to an embodiment of the present disclosure.

### DETAILED DESCRIPTION

References will now be made in detail to certain embodiments, of which examples are illustrated in the accompanying drawings, where like reference numerals refer to like elements throughout. The embodiments may have a variety of forms and permutations, but the present disclosure shall by no means be construed as being limited to the described embodiments. Rather, the present disclosure shall be construed to encompass all forms, permutations, equivalents and substitutes covered by the technical ideas and scope of the present disclosure. Accordingly, the example embodiments are described herein, by referring to the figures, to explain features of the present disclosure.

Like or identical reference numerals refer to like or identical elements. Moreover, in the accompanying drawings, the thicknesses, ratios, and dimensions of the elements may not be to exact scale and may have been exaggerated for the benefit of effective explanation of the technical features associated with these elements. As such, the present disclosure shall not be restricted to the thicknesses, ratios, dimensions, and other characteristics illustrated in the drawings.

When an element is described as "disposed on,'' "placed on,'' "arranged on,'' "connected to," or "coupled to" another element, it shall be construed as being disposed on, placed on, arranged on, connected to, or coupled to the other element directly but also as possibly having another element therebetween. In some embodiments, if one element is described as "directly disposed on," "directly placed on," "directly arranged on," "directly connected to," or "directly coupled to" another element, it shall be construed that there is no other element interposed therebetween.

Moreover, relative terms, such as, for example, "below," "under," "beneath," "lower," "bottom," "above," "over," "upper," "top," and the like, may be used herein to describe one element's relationship to another element as illustrated in the accompanying figures. It shall be understood that relative terms are intended to encompass different orientations of the device in addition to the orientation depicted in the accompanying figures. For example, if the device in one of the figures is turned over, elements described as being on the "lower" side of the other elements would then be oriented on "upper" sides of the other elements. The example term "lower" can therefore encompass an orientation of both "lower" and "upper," depending on the particular orientation of the figure. Similarly, if the device in one of the figures is turned over, elements described as "below" or "beneath" other elements would then be oriented "above" the other elements. The example term "below" or "beneath" can therefore encompass an orientation of both above and below.

Furthermore, when one device or layer is described as "on," "over," "above," and the like, another device or layer, it shall also encompass the case of yet another device or layer disposed on, over, above, and the like, the other device or layer or interposed between the one device or layer and the other device or layer. On the contrary, when one device or layer is described as "directly on," "directly over," "directly above," and the like, another device or layer, it shall mean that no other device or layer is interposed between the one device or layer and the other device or layer.

An expression such as, for example, "comprising" or "including" is intended to designate a characteristic, a number, a step, an operation, an element, a part or combinations thereof, and shall not be construed to preclude any possibility of presence or addition of one or more other characteristics, numbers, steps, operations, elements, parts or combinations thereof.

The term "adjacent" herein may refer to elements which are relatively close to each other (e.g., within a threshold distance). For example, for a first light-emitting diode (e.g., first light-emitting diode ED1) described as adjacent to another light-emitting diode (e.g., second light-emitting diode ED2, third light-emitting diode ED3), the light-emitting diodes may be spaced part by another element (e.g., a first encapsulation layer TFE1), but another light-emitting diode is not present between the adjacent light-emitting diodes.

Unless otherwise defined, all terms, including technical terms and scientific terms, used herein have the same meaning as how they are generally understood by those of ordinary skill in the art to which the present disclosure pertains. Any term that is defined in a general dictionary shall be construed to have the same meaning in the context of the relevant art, and, unless otherwise defined explicitly, shall not be interpreted to have an idealistic or excessively formalistic meaning.

Terms such as, for example, "first" and "second" may be used in describing various elements, but the elements shall not be restricted to such terms. The terms may be used to distinguish one element from the other. For instance, the first element may be named the second element, and vice versa, without departing the scope of claims of the present disclosure. Unless clearly used otherwise, any expressions in a singular form may include a meaning of a plural form. The term "and/or" shall include the combination of a plurality of listed items or any of the plurality of listed items.

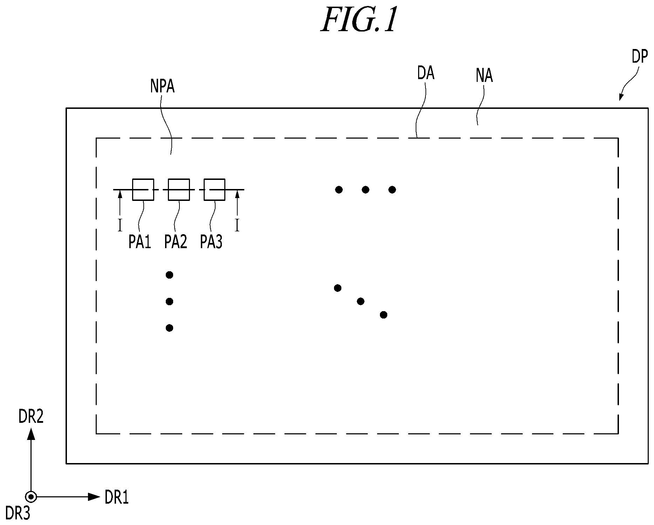

FIG. 1 is a plan view illustrating a display panel according to an embodiment of the present disclosure. Referring to FIG. 1, the display panel DP according to an embodiment of the present disclosure is a display panel of an image display device. The display panel DP may have a display area DA and a peripheral area NA defined therein. The display area DA is an area where an image is displayed. The peripheral area NA is an area positioned around the display area DA where the image is not displayed. In some embodiments, the peripheral area NA may be omitted. In the present embodiment, the display area DA is illustrated as having a rectangular shape, and the peripheral area NA is illustrated as surrounding the display area DA. However, the present disclosure is not limited to this configuration, and the shape of the display area DA and the shape of the peripheral area NA can be variously designed.

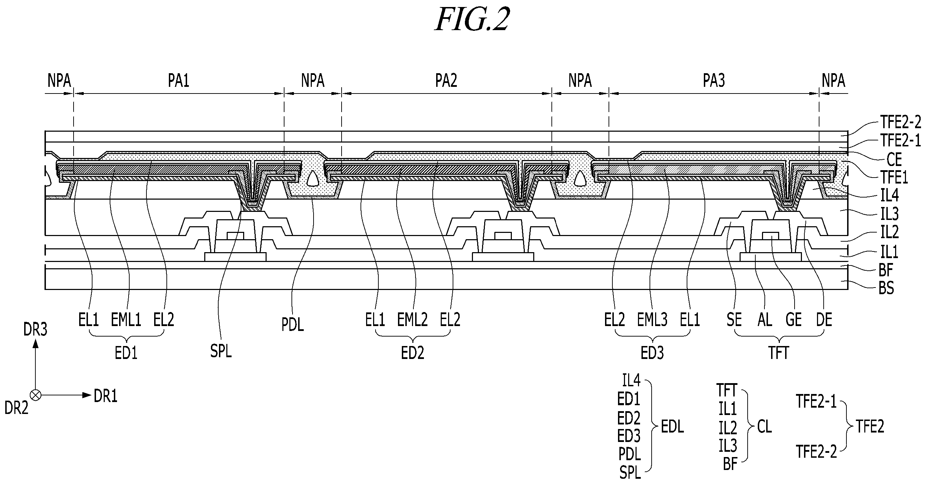

FIG. 2 is a cross-sectional view taken along line I-I of FIG. 1. Referring to FIGS. 1 and 2, the display area DAmay have light-emitting regions PA1, PA2, PA3 and a non-light-emitting region NPA defined therein. The light-emitting regions PA1, PA2, PA3 correspond to areas that respectively overlap with the light-emitting diodes ED1, ED2, ED3 in a planar view and may be areas where light emitted from the light-emitting diodes ED1, ED2, ED3 is displayed. The non-light-emitting region NPA may be an area defined between the light-emitting regions PA1, PA2, PA3 and may be an area corresponding to a pixel defining layer PDL.

The light-emitting regions PA1, PA2, PA3 may be defined as areas where the upper surface of the first electrode EL1 is exposed by the pixel defining layer PDL, and the non-light-emitting region NPA may define the boundaries of the light-emitting regions PA1, PA2, PA3. As a nonlimiting example, the light-emitting regions PA1, PA2, PA3 may include a first light-emitting region PA1, a second light-emitting region PA2, and a third light-emitting region PA3. In the light-emitting regions PA1, PA2, PA3, light emitted from a first light-emitting diode ED1 may be displayed in the first light-emitting region PA1, light emitted from a second light-emitting diode ED2 may be displayed in the second light-emitting region PA2, and light emitted from a third light-emitting diode ED3 may be displayed in the third light-emitting region PA3.

The light-emitting diodes ED1, ED2, ED3 may respectively emit light of different colors. For example, the first light-emitting diode ED1 may emit red light, the second light-emitting diode ED2 may emit blue light, and the third light-emitting diode ED3 may emit green light, although the present disclosure is not limited to this example. Each of the first to third light-emitting regions PA1, PA2, PA3 may be provided in plural, arranged in a predetermined pattern within the display area DA, and may be repeatedly disposed. For example, the first to third light-emitting regions PA1, PA2, PA3 may have, but not limited to, a Pentile^{™} arrangement, a stripe arrangement, or a Diamond Pixel^{™} arrangement. Each of the first to third light-emitting regions PA1, PA2, PA3 may have various shapes in a planar view. While the shapes of the first to third light-emitting regions PA1, PA2, PA3 are illustrated as rectangular in the drawings, this is an example, and these shapes may be circular, elliptical, polygonal, or other shapes. Although the areas of the first to third light-emitting regions PA1, PA2, PA3 are depicted as being the same size in the drawings, this is an example, and these areas may have different sizes.

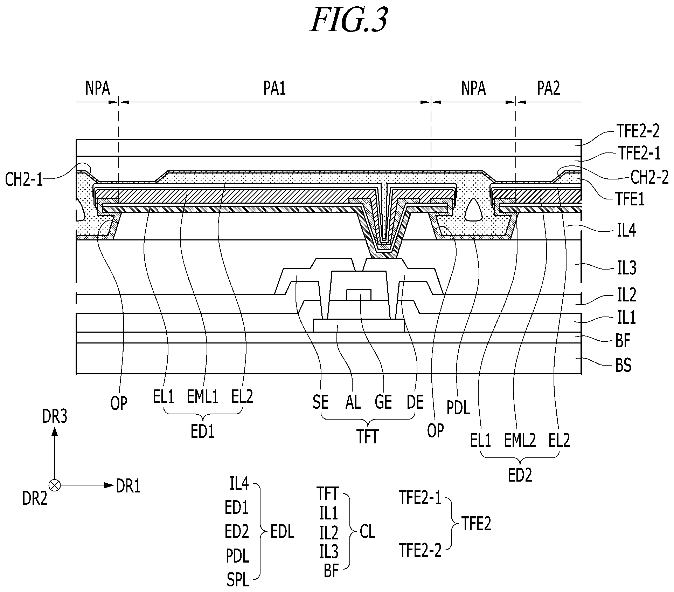

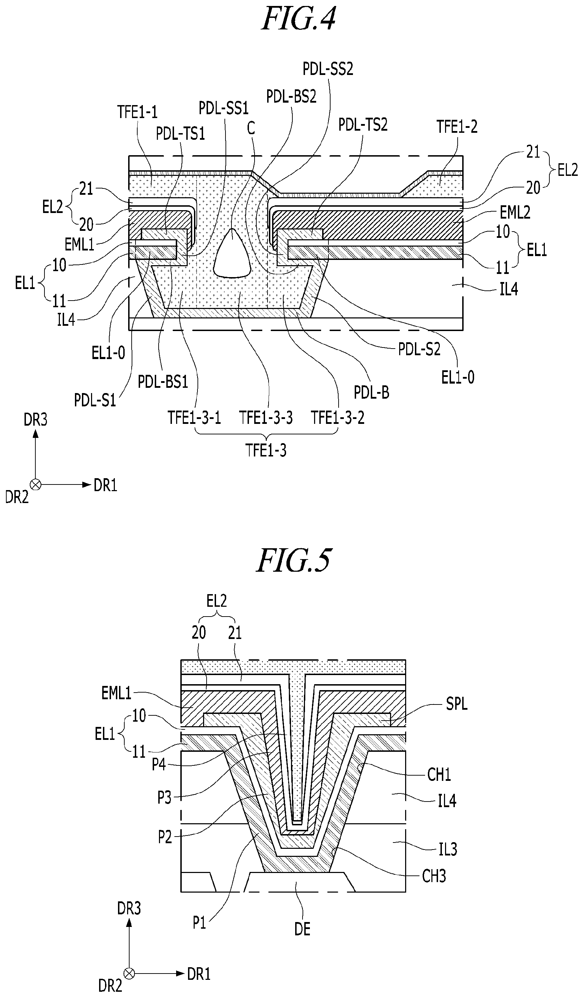

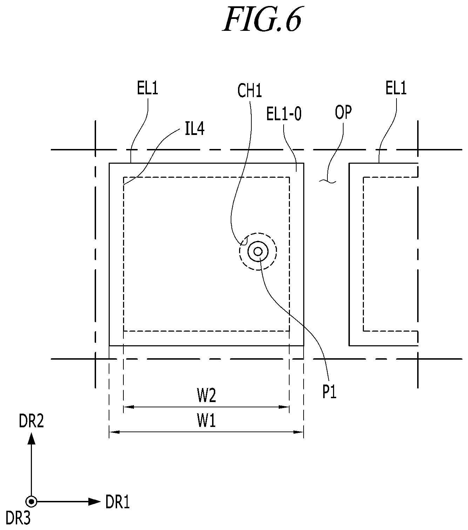

FIG. 3 is an enlarged view of a portion of FIG. 2, FIG. 4 is an enlarged view of a portion including the pixel defining layer in FIG. 3, FIG. 5 is an enlarged view of a portion including the short-circuit prevention layer in FIG. 3, and FIG. 6 illustrates only the insulating layer and the first electrode of the display element layer illustrated in FIG. 3.

Referring to FIGS. 2 to 6, the display panel DP may include a substrate BS, a circuit layer CL, a display element layer EDL, a first encapsulation layer TFE1, a common electrode CE, and a second encapsulation layer TFE2.

The substrate BS may be an element that provides a base surface on which the circuit layer CL is disposed. The substrate BS may include glass, ceramic, metal, or a polymer resin such as, for example, polyimide. However, the present disclosure is not limited to these materials, and the substrate BS may be an inorganic layer, an organic layer, or a composite material layer, and may be formed as a single layer or multiple layers.

The circuit layer CL may be disposed on the substrate BS. The circuit layer CL may include transistors TFT, a first insulating layer IL1, a second insulating layer IL2, and a third insulating layer IL3. In some embodiments, the circuit layer CL may further include a buffer layer BF. Each of the transistors TFT may be configured to apply an electrical signal to each of the light-emitting diodes ED1, ED2, ED3. Each of the transistors TFT may include an active layer AL, which is a semiconductor pattern, a gate electrode GE, and a source electrode SE and a drain electrode DE that are electrically connected to the active layer AL. The first insulating layer IL1 may be disposed on the substrate BS and cover the active layer AL. The second insulating layer IL2 may be disposed on the first insulating layer IL1 and cover the gate electrode GE. The third insulating layer IL3 may be disposed on the second insulating layer IL2 and cover the source electrode SE and the drain electrode DE. Each of the first to third insulating layers IL1, IL2, IL3 may be an inorganic layer or an organic layer. The buffer layer BF may be disposed between the substrate BS and the first insulating layer IL1. The buffer layer BF may improve the adhesion of the semiconductor pattern disposed on the buffer layer BF. The buffer layer BF may be an inorganic layer that includes at least one inorganic material selected from silicon nitride, silicon oxide, and silicon oxynitride.

The display element layer EDL may be disposed on the circuit layer CL. The display element layer EDL may include a fourth insulating layer IL4, light-emitting diodes ED1, ED2, ED3, and a pixel defining layer PDL. In some embodiments, the display element layer EDL may further include a short-circuit prevention layer SPL.

The fourth insulating layer IL4 may be disposed on the third insulating layer IL3 of the circuit layer CL. The fourth insulating layer IL4 is provided with an opening OP. The opening OP need not overlap with the light-emitting regions PA1, PA2, PA3 in a planar view and may overlap with the non-light-emitting region NPA. However, the present disclosure is not limited to this configuration, and the opening OP may cover the non-light-emitting region NPA in a planar view. At least a portion of the opening OP may surround each of the light-emitting regions PA1, PA2, PA3 in a planar view. The fourth insulating layer IL4 may include silicon nitride (SiNx), silicon oxide (SiOx), silicon oxynitride (SiOxNy), or the like.

Descriptions herein that an element (e.g., a layer) "may be provided with" another element (e.g., an opening, a protrusion) include descriptions of the other element being formed in or on the element.

Each of the light-emitting diodes ED1, ED2, ED3 may be disposed on the fourth insulating layer IL4. Each of the light-emitting diodes ED1, ED2, ED3 may include a first electrode EL1 and a second electrode EL2. The light-emitting diodes ED1, ED2, ED3 may respectively include light-emitting layers EML1, EML2, EML3. In some embodiments, a hole functional layer (not illustrated) may be included between the first electrode EL1 and the light-emitting layers EML1, EML2, EML3. In some embodiments, an electron functional layer (not illustrated) may be included between the light-emitting layers EML1, EML2, EML3 and the second electrode EL2. However, the present disclosure is not limited to this configuration, and the positions of the hole functional layer and the electron functional layer may be switched depending on whether the first electrode EL1 and the second electrode EL2 are, respectively, anodes or cathodes.

The first electrode EL1 is disposed on the fourth insulating layer IL4, and an edge portion EL1-0 of the first electrode EL1 may overlap with the opening OP in a planar view. The width W1 of the first electrode EL1 in the first direction DR1 may be greater than the width W2 of the upper surface of the fourth insulating layer IL4 in the first direction DR1. Here, the first direction DR1 may be a direction parallel to the substrate BS, and the upper surface of the fourth insulating layer IL4 may be a surface that contacts or faces the first electrode EL1 in a cross-sectional view. As a result, an undercut shape may be provided by the fourth insulating layer IL4 and the first electrode EL1 disposed on the fourth insulating layer IL4. Here, the undercut shape may refer to a shape defined by the side surface of the fourth insulating layer IL4 and the lower surface of the edge portion EL1-0 of the first electrode EL1.

In some embodiments, although the side surface of the fourth insulating layer IL4, which defines the opening OP, is illustrated in the drawings as forming an acute angle with the lower surface of the edge portion EL1-0 of the first electrode EL1, the present disclosure is not limited to this configuration. For example, the fourth insulating layer IL4 may have a truncated cone shape, as illustrated in the drawings, or may have an inverted truncated cone shape or a columnar shape with a constant cross-sectional area, even though these shapes are not illustrated in the drawings.

The light-emitting layers EML1, EML2, EML3 are disposed on the first electrode EL1. For example, a first light-emitting layer EML1, which is configured to generate red light, may be disposed on the first electrode EL1 of the first light-emitting diode ED1, a second light-emitting layer EML2, which is configured to generate blue light, may be disposed on the first electrode EL1 of the second light-emitting diode ED2, and a third light-emitting layer EML3, which is configured to generate green light, may be disposed on the first electrode EL1 of the third light-emitting diode ED3. However, the present disclosure is not limited to these configurations.

The second electrode EL2 may be disposed on each of the light-emitting layers EML1, EML2, EML3. For example, the second electrode EL2 may be disposed on the first light-emitting layer EML1 of the first light-emitting diode ED1, the second light-emitting layer EML2 of the second light-emitting diode ED2, and the third light-emitting layer EML3 of the third light-emitting diode ED3.

The pixel defining layer PDL may surround the upper surface, a side surface, and the lower surface of the edge portion EL1-0 of the first electrode EL1 of each of the light-emitting diodes ED1, ED2, ED3. The pixel defining layer PDL may be an insulating film that includes an inorganic material. For example, the pixel defining layer PDL may include silicon nitride (SiNx), silicon oxide (SiOx), silicon oxynitride (SiOxNy), or the like. As a result, the issue of current leakage at the edge portion EL1-0 of the first electrode EL1 may be improved.

The pixel defining layer PDL may extend along the side surfaces and bottom surface of the opening OP provided in the fourth insulating layer IL4 and may have an integrated shape that connects the portions of the pixel defining layer PDL that respectively surround the edge portions EL1-0 of the first electrodes EL1 of the light-emitting diodes ED1, ED2, ED3. For example, the pixel defining layer PDL may include a first upper portion PDL-TS1, a first side portion PDL-SS1, a first lower portion PDL-BS1, a second upper portion PDL-TS2, a second side portion PDL-SS2, a second lower portion PDL-BS2, a first side portion PDL-S1, a second side portion PDL-S2, and a bottom portion PDL-B.

The first upper portion PDL-TS1 may surround the upper surface of the edge portion EL1-0 of the first electrode EL1 of the first light-emitting diode ED1. The first side portion PDL-SS1 may surround the side surface of the edge portion EL1-0 of the first electrode EL1 of the first light-emitting diode ED1. The first lower portion PDL-BS1 may surround the lower surface of the edge portion EL1-0 of the first electrode EL1 of the first light-emitting diode ED1. The second upper portion PDL-TS2 may surround the upper surface of the edge portion EL1-0 of the first electrode EL1 of the second light-emitting diode ED2. The second side portion PDL-SS2 may surround the side surface of the edge portion EL1-0 of the first electrode EL1 of the second light-emitting diode ED2. The second lower portion PDL-BS2 may surround the lower surface of the edge portion EL1-0 of the first electrode EL1 of the second light-emitting diode ED2. The first side portion PDL-S1 may extend from the first lower portion PDL-BS1 along one side of the opening OP. The second side portion PDL-S2 may extend from the second lower portion PDL-BS2 along the other side of the opening OP. The bottom portion PDL-B may extend along the bottom surface of the opening OP and connect the first side portion PDL-S1 and the second side portion PDL-S2.

The short-circuit prevention layer SPL may be configured to prevent a short circuit between the first electrode EL1 and the second electrode EL2 within the first contact hole CH1 provided in the fourth insulating layer IL4. The first contact hole CH1 may overlap with the drain electrode DE of the transistor TFT in a planar view and may be provided so as not to overlap with the opening OP in the fourth insulating layer IL4. The first electrode EL1 may be electrically connected to the drain electrode DE of the transistor TFT through the first contact hole CH1.

In the present embodiment, the first electrode EL1 may be directly connected to the drain electrode DE of the transistor TFT. To this end, the third insulating layer IL3 of the circuit layer CL may be provided with a third contact hole CH3 that is connected to the first contact hole CH1 of the fourth insulating layer IL4. The first electrode EL1, the light-emitting layers EML1, EML2, EML3, and the second electrode EL2 of the light-emitting diodes ED1, ED2, ED3 may each cover the first contact hole CH1 in a planar view. The short-circuit prevention layer SPL may be disposed between the first electrode EL1 and the light-emitting layers EML1, EML2, EML3 of the light-emitting diodes ED1, ED2, ED3, and may cover the first contact hole CH1 in a planar view.

The first electrode EL1 may be provided with a first protrusion P1 that extends in a direction opposite to the third direction DR3 toward the drain electrode DE of the transistor TFT in a region overlapping with the first contact hole CH1 in a planar view. The short-circuit prevention layer SPL may be provided with a second protrusion P2 that extends in the direction opposite to the third direction DR3 toward the drain electrode DE of the transistor TFT in the region overlapping with the first contact hole CH1 in a planar view and is disposed within the first protrusion P1. The light-emitting layers EML1, EML2, EML3 may be provided with a third protrusion P3 that extends in the direction opposite to the third direction DR3 toward the drain electrode DE of the transistor TFT in the region overlapping with the first contact hole CH1 in a planar view and is disposed within the second protrusion P2. The second electrode EL2 may be provided with a fourth protrusion P4 that extends in the direction opposite to the third direction DR3 toward the drain electrode DE of the transistor TFT in the region overlapping with the first contact hole CH1 in a planar view and is disposed within the third protrusion P3.

As a result, even if the light-emitting layers EML1, EML2, EML3, disposed between the first electrode EL1 and the second electrode EL2 are formed with a relatively small thickness in some regions within the first contact hole CH1, a short circuit between the first electrode EL1 and the second electrode EL2 may be prevented by the short-circuit prevention layer SPL. Here, the third direction DR3 may refer to a direction perpendicular to the upper surface of the substrate BS. Each of the first to fourth protrusions P1, P2, P3, and P4 may have a truncated cone shape with an open top surface and a closed bottom surface.

In some embodiments, the first electrode EL1 may further include a metal layer 11 in addition to the anode electrode 10, which may improve the electrical connectivity between the first electrode EL1 and the transistor TFT through the first contact hole CH1. The metal layer 11 may be disposed on the fourth insulating layer IL4, and the anode electrode 10 may be disposed on the metal layer 11. The anode electrode 10 may include multiple layers. For example, the anode electrode 10 may include an Ag layer containing silver (Ag) and an ITO layer containing indium tin oxide (ITO). The Ag layer may be disposed on the metal layer 11, and the ITO layer may be disposed on the Ag layer. The metal layer 11 may include a metal with excellent step coverage. For example, the metal layer 11 may include one of titanium (Ti), molybdenum (Mo), niobium (Nb), and tantalum (Ta).

The first encapsulation layer TFE1 and the second encapsulation layer TFE2 may be configured to seal the light-emitting diodes ED1, ED2, ED3 and provide protection from moisture, oxygen, and/or foreign substances. The first encapsulation layer TFE1 may be disposed on the light-emitting diodes ED1, ED2, ED3. The first encapsulation layer TFE1 separates the second electrodes EL2 of the light-emitting diodes ED1, ED2, ED3 from each other in the region overlapping with the opening OP in a planar view. In other words, the side surface of the second electrode EL2 of the first light-emitting diode ED1 and the side surface of the second electrode EL2 of the second light-emitting diode ED2 may be disposed in a region overlapping with the opening OP in a planar view, and the first encapsulation layer TFE1 may cover the side surfaces of the second electrodes EL2 of the first light-emitting diode ED1 and the second light-emitting diode ED2 in a cross-sectional view. Here, the side surface of the second electrode EL2 of the first light-emitting diode ED1 and the side surface of the second electrode EL2 of the second light-emitting diode ED2 may refer to the surfaces facing each other.

Hereinafter, the structure of the first encapsulation layer TFE1 for separating the second electrode EL2 of the first light-emitting diode ED1 from the second electrode EL2 of the second light-emitting diode ED2 will be described with reference to the accompanying drawings. It shall be readily understood by those skilled in the art that the same description can be applied to the separation between the second electrode EL2 of the first light-emitting diode ED1 and the second electrode EL2 of the third light-emitting diode ED3, as well as between the second electrode EL2 of the second light-emitting diode ED2 and the second electrode EL2 of the third light-emitting diode ED3.

The first encapsulation layer TFE1 may include first through third portions TFE1-1, TFE1-2, and TFE1-3. The first portion TFE1-1 may overlap with the second electrode EL2 of the first light-emitting diode ED1 in a planar view and may be disposed on the second electrode EL2 of the first light-emitting diode ED1. The second portion TFE1-2 may overlap with the second electrode EL2 of the second light-emitting diode ED2 in a planar view and may be disposed on the second electrode EL2 of the second light-emitting diode ED2. The third portion TFE1-3 may connect the first portion TFE1-1 and the second portion TFE1-2 in the region overlapping with the opening OP in a planar view. The first through third portions TFE1-1, TFE1-2, and TFE1-3 may have an integrated shape.

The third portion TFE1-3 may include first through third sub-portions TFE1-3-1, TFE1-3-2, and TFE1-3-3. The first sub-portion TFE1-3-1 may overlap with the second electrode EL2 of the first light-emitting diode ED1 in a planar view and may be disposed beneath the second electrode EL2 of the first light-emitting diode ED1. The second sub-portion TFE1-3-2 may overlap with the second electrode EL2 of the second light-emitting diode ED2 in a planar view and may be disposed beneath the second electrode EL2 of the second light-emitting diode ED2. The third sub-portion TFE1-3-3 may be disposed between the second electrode EL2 of the first light-emitting diode ED1 and the second electrode EL2 of the second light-emitting diode ED2 in a planar view and may connect the first portion TFE1-1, the second portion TFE1-2, the first sub-portion TFE1-3-1, and the second sub-portion TFE1-3-2. As a result, the second electrode EL2 of the first light-emitting diode ED1 may be spaced apart from the second electrode EL2 of the second light-emitting diode ED2 in the region overlapping with the opening OP in a planar view.

The upper surface of the third sub-portion TFE1-3-3 of the first encapsulation layer TFE1 may be positioned higher than the second electrodes EL2 of the first light-emitting diode ED1 and the second light-emitting diode ED2 across the entire region between the second electrode EL2 of the first light-emitting diode ED1 and the second electrode EL2 of the second light-emitting diode ED2 in a cross-sectional view. In other words, in the entire region between the second electrode EL2 of the first light-emitting diode ED1 and the second electrode EL2 of the second light-emitting diode ED2, the distance in the third direction DR3 from the upper surface of the bottom portion PDL-B of the pixel defining layer PDL to the upper surface of the third sub-portion TFE1-3-3 may be greater than the distance in the third direction DR3 from the upper surface of the bottom portion PDL-B of the pixel defining layer PDL to the upper surface of the second electrode EL2 of the first light-emitting diode ED1, and greater than the distance in the third direction DR3 from the upper surface of the bottom portion PDL-B of the pixel defining layer PDL to the upper surface of the second electrode EL2 of the second light-emitting diode ED2. As a result, the issue of the common electrode CE, which is for connecting the second electrode EL2 of the first light-emitting diode ED1 and the second electrode EL2 of the second light-emitting diode ED2, being interrupted in the region overlapping with the opening OP in a planar view may be improved. For example, if a depression extending toward the bottom surface of the opening OP is formed to a certain depth on the upper surface of the first encapsulation layer TFE1 in the region between the second electrode EL2 of the first light-emitting diode ED1 and the second electrode EL2 of the second light-emitting diode ED2, the common electrode CE formed on the first encapsulation layer TFE1 may be interrupted at the depression.

The first encapsulation layer TFE1 may include an inorganic material. For example, the first encapsulation layer TFE1 may include, but is not necessarily limited to, silicon nitride, silicon oxynitride, silicon oxide, titanium oxide, or aluminum oxide.

A cavity C, which is a sealed space defined by the first encapsulation layer TFE1, may be provided between the upper surface and the lower surface of the third sub-portion TFE1-3-3 of the first encapsulation layer TFE1. The cavity C may be naturally formed during the process of forming the first encapsulation layer TFE1 in the manufacturing process of the display panel DP if the first encapsulation layer TFE1 includes an inorganic material. The cavity C may be disposed between the first light-emitting diode ED1 and the second light-emitting diode ED2 along the first direction DR1.

The first encapsulation layer TFE1 may be provided with second contact holes CH2-1, CH2-2 that expose portions of the upper surfaces of the second electrodes EL2 of the light-emitting diodes ED1, ED2. Although the reference numerals are omitted in the drawings for convenience, the first encapsulation layer TFE1 may also be provided with a second contact hole that exposes a portion of the upper surface of the second electrode EL2 of the third light-emitting diode ED3.

The common electrode CE may be disposed on the first encapsulation layer TFE1. The common electrode CE may be connected to the second electrodes EL2 of the light-emitting diodes ED1, ED2 through the second contact holes CH2-1, CH2-2. Specifically, the second contact holes CH2-1, CH2-2 may include a first sub-contact hole CH2-1 that exposes a portion of the upper surface of the second electrode EL2 of the first light-emitting diode ED1, and a second sub-contact hole CH2-2 that exposes a portion of the upper surface of the second electrode EL2 of the second light-emitting diode ED2. The common electrode CE may be connected to the second electrode EL2 of the first light-emitting diode ED1 through the first sub-contact hole CH2-1. The common electrode CE may be connected to the second electrode EL2 of the second light-emitting diode ED2 through the second sub-contact hole CH2-2. The common electrode CE may have an integrated shape, such that the second electrode EL2 of the first light-emitting diode ED1 and the second electrode EL2 of the second light-emitting diode ED2 are connected through the common electrode CE.

The second encapsulation layer TFE2 may be disposed on the common electrode CE. The second encapsulation layer TFE2 may include a fourth sub-encapsulation layer TFE2-1 disposed on the common electrode CE and a fifth sub-encapsulation layer TFE2-2 disposed on the fourth sub-encapsulation layer TFE2-1. The fourth sub-encapsulation layer TFE2-1 may include an organic material. For example, the fourth sub-encapsulation layer TFE2-1 may include acrylic compounds, epoxy compounds, and the like. The fourth sub-encapsulation layer TFE2-1 may include, but not particularly limited to, a photopolymerizable organic material. The fourth sub-encapsulation layer TFE2-1 may include a monomer. The fifth sub-encapsulation layer TFE2-2 may include an inorganic material. For example, the fifth sub-encapsulation layer TFE2-2 may include, but not limited to, silicon nitride, silicon oxynitride, silicon oxide, titanium oxide, or aluminum oxide. The fourth sub-encapsulation layer TFE2-1 may cover the common electrode CE in a planar view, and the fifth sub-encapsulation layer TFE2-2 may cover the fourth sub-encapsulation layer TFE2-1 in a planar view.

In some embodiments, to protect the cathode electrode during the formation of the second contact holes CH2-1, CH2-2 and subsequent processes, the second electrode EL2 may further include a protective electrode 21 in addition to the cathode electrode 20. The cathode electrode 20 may be disposed on the light-emitting layers EML1, EML2, EML3, and the protective electrode 21 may be disposed on the cathode electrode 20. The protective electrode 21 may include a transparent conductive oxide (TCO). For example, the protective electrode 21 may include ITO (Indium Tin Oxide) or IZO (Indium Zinc Oxide) and may improve moisture barrier properties.

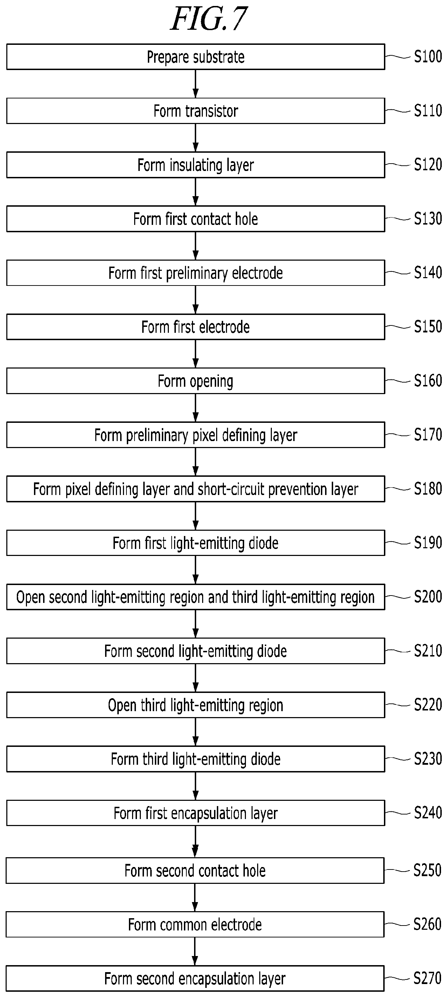

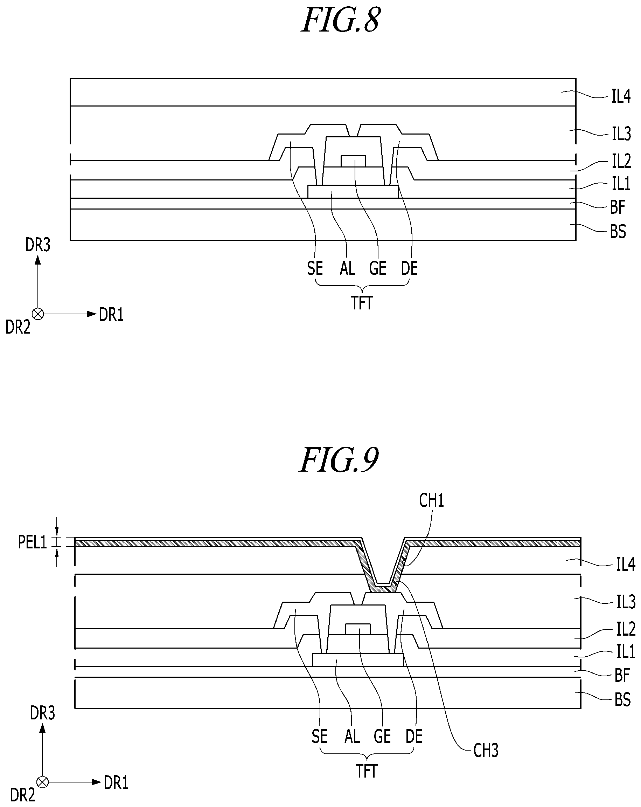

FIG. 7 is a flowchart illustrating a method for manufacturing a display panel according to an embodiment of the present disclosure, and FIGS. 8 to 19 are diagrams for explaining each step of the method for manufacturing the display panel illustrated in FIG. 7.

In the descriptions of the method and processes herein, the operations may be performed in a different order than the order shown and/or described, or the operations may be performed in different orders or at different times. Certain operations may also be left out of the flowcharts, one or more operations may be repeated, or other operations may be added. Descriptions that an element "may be disposed," "may be formed," and the like include methods, processes, and techniques for disposing, forming, positioning, and modifying the element, and the like in accordance with example aspects described herein.

Referring to FIG. 7, the method for manufacturing a display panel according to an embodiment of the present disclosure may include: preparing a substrate (S100), forming a transistor (S110), forming an insulating layer (S120), forming a first contact hole (S130), forming a first preliminary electrode (S140), forming a first electrode (S150), forming an opening (S 160), forming a preliminary pixel defining layer (S170), forming a pixel defining layer and a short-circuit prevention layer (S180), forming a first light-emitting diode (S190), opening a second light-emitting region and a third light-emitting region (S200), forming a second light-emitting diode (S210), opening the third light-emitting region (S220), forming a third light-emitting diode (S230), forming a first encapsulation layer (S240), forming a second contact hole (S250), forming a common electrode (S260), and forming a second encapsulation layer (S270).

Hereinafter, each step of the method for manufacturing the display panel DP will be described with reference to FIGS. 8 to 19. The aforementioned descriptions related to each element of the display panel DP may also apply as-is to the elements formed by this manufacturing method, each of which is assigned the same reference numerals.

Referring to FIG. 8, in the step of preparing a substrate (S100), the method may include preparing a substrate BS, and in the step of forming a transistor (S110), the method may include forming a circuit layer CL including transistors TFT on the substrate BS. In the step of forming an insulating layer (S120), the method may include forming a fourth insulating layer IL4 on the circuit layer CL.

Referring to FIG. 9, in the step of forming a first contact hole (S130), the method may include forming a first contact hole CH1 that overlaps with the drain electrode DE of the transistor TFT, in the fourth insulating layer IL4. At this time, a third contact hole CH3 connecting the drain electrode DE of the transistor TFT to the first contact hole CH1 may be formed in the third insulating layer IL3 of the circuit layer CL. For example, the first contact hole CH1 and the third contact hole CH3 may be formed to have an integrated shape (are integral/ integrated with each other) using the same photomask.

In the step of forming a first preliminary electrode (S140), the method may include forming a first preliminary electrode PEL1 on the fourth insulating layer IL4. The first preliminary electrode PEL1 may be formed using an open mask. Accordingly, the first preliminary electrode PEL1 may also be formed in the region overlapping with the first contact hole CH1 in a planar view. The first preliminary electrode PEL1 may include multiple layers for forming the anode electrode 10 and the metal layer 11. The multiple layers of the first preliminary electrode PEL1 may be formed collectively by sputtering deposition.

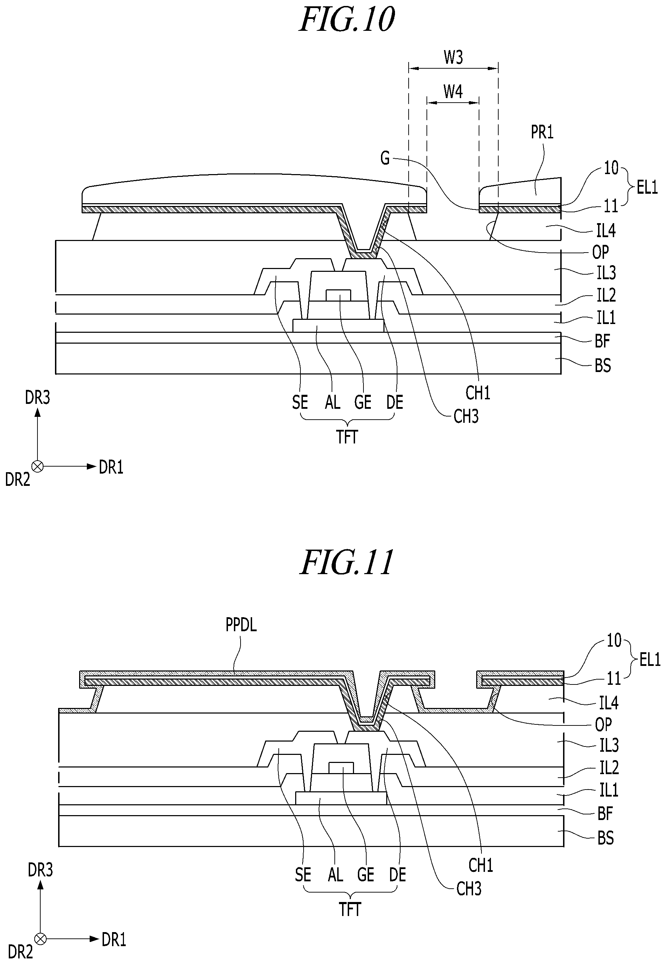

Referring to FIG. 10, in the step of forming a first electrode (S150), the method may include etching the first preliminary electrode PEL1 in association with forming the first electrodes EL1. The anode electrode 10 of the first electrode EL1 may be formed by a wet etching process, and the metal layer 11 of the first electrode EL1 may be formed by a dry etching process. In the step of forming an opening (S160), the method may include etching the fourth insulating layer IL4 through the gap G formed between the first electrodes EL1 in association with forming an opening OP in the fourth insulating layer IL4. The opening OP may be formed by an isotropic dry etching process. As a result, an undercut shape may be formed by the fourth insulating layer IL4 and the first electrodes EL1 formed on the fourth insulating layer IL4. That is, the width W3 of the upper end of the opening OP, which contacts the first electrodes EL1, may be greater than the width W4 of the gap G formed between the first electrodes EL1. The method may include carrying out the step of forming the first electrode (S150) and the step of forming the opening (S160) using a first photomask PR1 without replacing the photomask.

Referring to FIG. 11, in the step of forming a preliminary pixel defining layer (S170), the method may include forming a preliminary pixel defining layer PPDL on the first electrodes EL1. The preliminary pixel defining layer PPDL may be formed using an open mask. Accordingly, the preliminary pixel defining layer PPDL may cover the entirety of the first electrodes EL1 and the opening OP in a planar view. The preliminary pixel defining layer PPDL may be an inorganic layer that includes an inorganic material. As a result, the preliminary pixel defining layer PPDL may be formed not only on a portion of the upper surface of the third insulating layer IL3 defining the opening OP but also on the side surfaces of the fourth insulating layer IL4 defining the opening OP and on the lower surfaces of the first electrodes EL1.

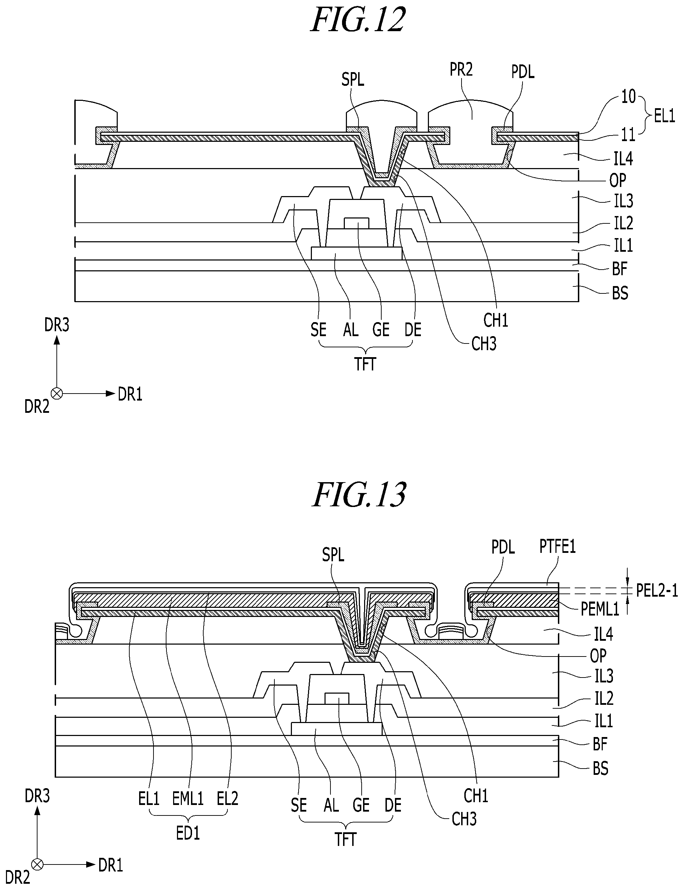

Referring to FIG. 12, in the step of forming a pixel defining layer and a short-circuit prevention layer (S180), the method may include forming a pixel defining layer PDL and a short-circuit prevention layer SPL by etching the preliminary pixel defining layer PPDL using a second photomask PR2. In this embodiment, the pixel defining layer PDL and the short-circuit prevention layer SPL may be formed from the same common layer, which is the preliminary pixel defining layer PPDL. Accordingly, while the short-circuit prevention layer SPL does not overlap with the pixel defining layer PDL in a planar view, the short-circuit prevention layer SPL may be formed of the same material as the pixel defining layer PDL.

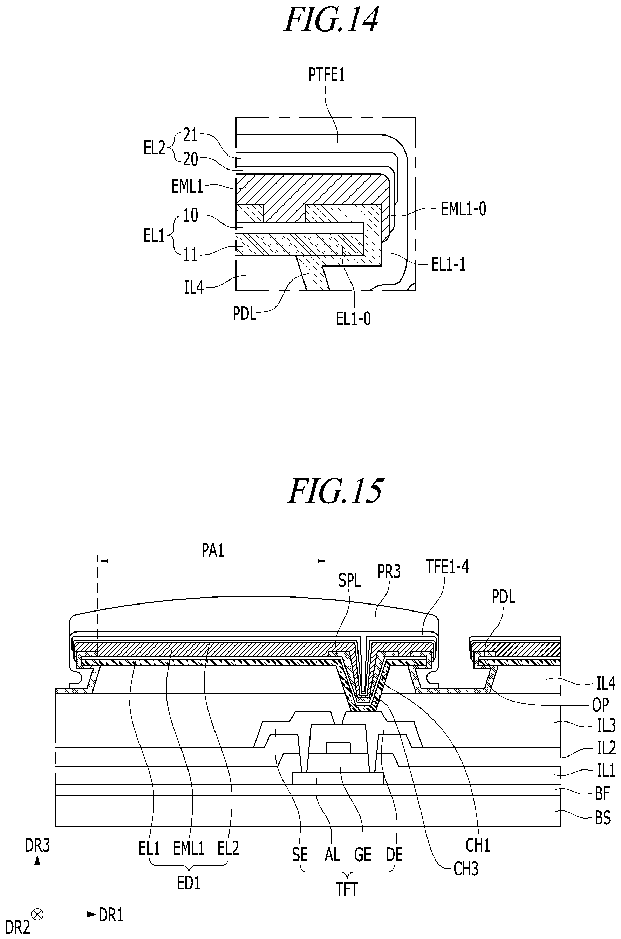

Referring to FIG. 13 and the enlarged portion in FIG. 14, in the step of forming a first light-emitting diode (S190), the method may include sequentially stacking a first preliminary light-emitting layer PEML1, a first preliminary sub-electrode PEL2-1, and a first preliminary encapsulation layer PTFE1 on the fourth insulating layer IL4. The first preliminary sub-electrode PEL2-1 may include multiple layers for forming a cathode electrode 20 and a protective electrode 21. The first preliminary light-emitting layer PEML1, the first preliminary sub-electrode PEL2-1, and the first preliminary encapsulation layer PTFE1 may be formed using an open mask. Accordingly, the first preliminary light-emitting layer PEML1, the first preliminary sub-electrode PEL2-1, and the first preliminary encapsulation layer PTFE1 may be stacked not only on the first electrodes EL1 but also on the portion of the upper surface of the pixel defining layer PDL that do not overlap with the first electrodes EL1 in a planar view. Due to the undercut shape formed by the fourth insulating layer IL4 and the first electrodes EL1 formed on the fourth insulating layer IL4, the first preliminary light-emitting layer PEML1, the first preliminary sub-electrode PEL2-1, and the first preliminary encapsulation layer PTFE1 may be naturally divided during the stacking process. As a result, first light-emitting diodes ED1, each including the first electrode EL1, the first light-emitting layer EML1, and the second electrode EL2, may be formed.

The first light-emitting layer EML1, formed on the first electrode EL1 of the first light-emitting diode ED1 by the first preliminary light-emitting layer PEML1 naturally divided due to the undercut shape, may cover the first electrode EL1 of the first light-emitting diode ED1 in a planar view, and at least a part of the first light-emitting layer EML1 may be disposed on the side surface EL1-1 of the first electrode EL1 of the first light-emitting diode ED1. Similarly, the second electrode EL2, formed on the first light-emitting layer EML1 of the first light-emitting diode ED1 by the first preliminary sub-electrode PEL2-1 naturally divided due to the undercut shape, may cover the first light-emitting layer EML1 in a planar view, and at least a part of the second electrode EL2 of the first light-emitting diode ED1 may be disposed on the side surface EML1-0 of the first light-emitting layer EML1. These characteristics may be similarly applied to the second light-emitting layer EML2 and second electrode EL2 of the second light-emitting diode ED2, as well as the third light-emitting layer EML3 and second electrode EL2 of the third light-emitting diode ED3.

Referring to FIG. 15, in the step of opening a second light-emitting region and a third light-emitting region (S200), the method may include covering the first light-emitting diodes ED1 corresponding to the first light-emitting region PA1 among the first light-emitting diodes ED1 with a third photomask PR3, and etching the first preliminary light-emitting layer PEML1, the first preliminary sub-electrode PEL2-1, and the first preliminary encapsulation layer PTFE1. As a result, the first electrodes EL1 corresponding to the second light-emitting region PA2 and the third light-emitting region PA3 may be exposed. In some embodiments, a first sub-encapsulation layer TFE1-4 may be formed on each of the first light-emitting diodes ED1 corresponding to the first light-emitting region PA1. The first sub-encapsulation layer TFE1-4 may cover each of the first light-emitting diodes ED1, protecting each of the first light-emitting diodes ED1 during subsequent processes.

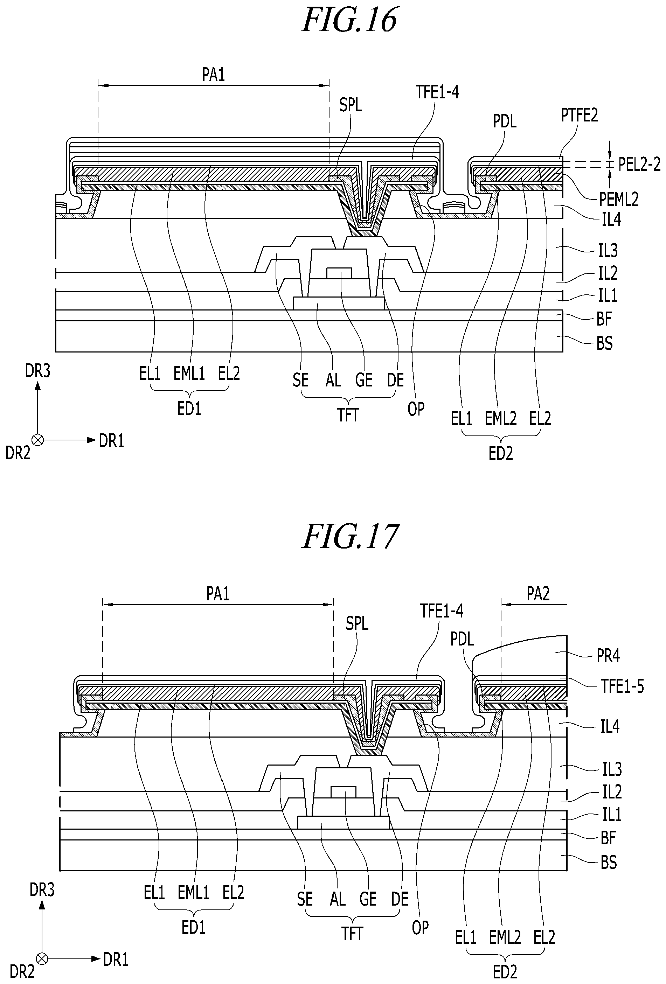

Referring to FIG. 16, in the step of forming a second light-emitting diode (S210), the method may include sequentially stacking a second preliminary light-emitting layer PENIL2, a second preliminary sub-electrode PEL2-2, and a second preliminary encapsulation layer PTFE2 on the fourth insulating layer IL4. The second preliminary sub-electrode PEL2-2 may include multiple layers for forming the cathode electrode 20 and the protective electrode 21. The second preliminary light-emitting layer PENIL2, the second preliminary sub-electrode PEL2-2, and the second preliminary encapsulation layer PTFE2 may be formed using an open mask. Accordingly, the second preliminary light-emitting layer PENIL2, the second preliminary sub-electrode PEL2-2, and the second preliminary encapsulation layer PTFE2 may be stacked not only on the first electrodes EL1 that have been exposed through the step of opening the second light-emitting region and the third light-emitting region (S200) but also on the portion of the upper surface of the pixel defining layer PDL that do not overlap with the first electrodes EL1 in a planar view and on the first sub-encapsulation layer TFE1-4. Due to the undercut shape formed by the fourth insulating layer IL4 and the first electrodes EL1 on the fourth insulating layer IL4, the second preliminary light-emitting layer PENIL2, the second preliminary sub-electrode PEL2-2, and the second preliminary encapsulation layer PTFE2 may be naturally divided during the stacking process. As a result, second light-emitting diodes ED2, each including the first electrode EL1, the second light-emitting layer EML2, and the second electrode EL2, may be formed.

Referring to FIG. 17, in the step of opening the third light-emitting region (S220), the method may include covering the second light-emitting diodes ED2 corresponding to the second light-emitting region PA2 with a fourth photomask PR4, and etching the second preliminary light-emitting layer PENIL2, the second preliminary sub-electrode PEL2-2, and the second preliminary encapsulation layer PTFE2. As a result, the first electrodes EL1 corresponding to the third light-emitting region PA3 and the first sub-encapsulation layer TFE1-4 may be exposed. In some aspects, a second sub-encapsulation layer TFE1-5 may be formed on each of the second light-emitting diodes ED2 corresponding to the second light-emitting region PA2. The second sub-encapsulation layer TFE1-5 may cover each of the second light-emitting diodes ED2, protecting each of the second light-emitting diodes ED2 during subsequent processes. Although the step of forming a third light-emitting diode (S230) is not illustrated in the drawings, the method may include performing the step in the same manner as the step of forming the second light-emitting diode (S210). In this step, a third preliminary light-emitting layer, a third preliminary sub-electrode, a third preliminary encapsulation layer, and a fifth photomask may be used.

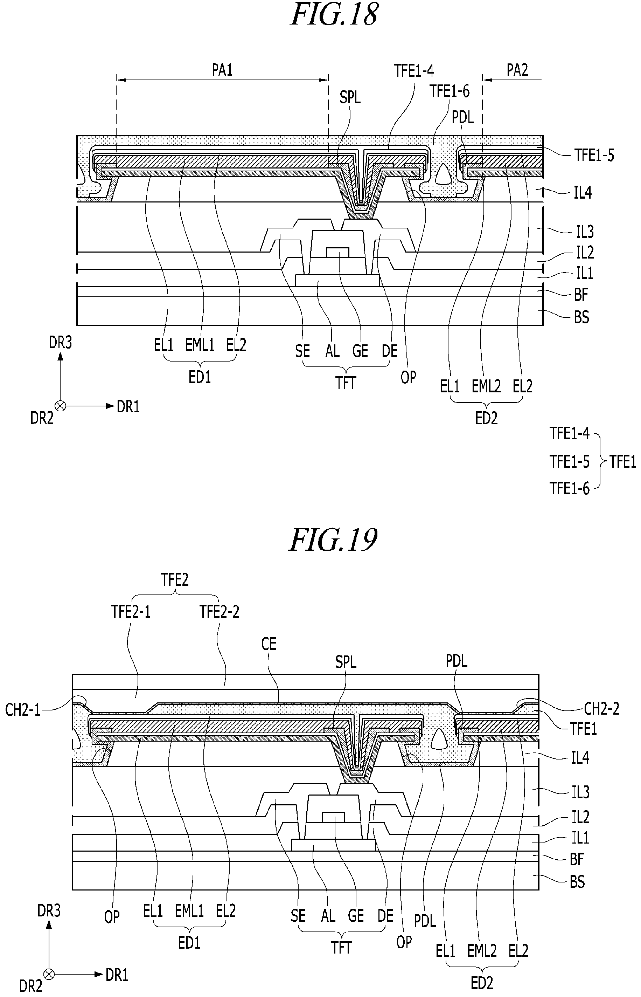

Referring to FIG. 18, in the step of forming a first encapsulation layer (S240), the method may include stacking a third sub-encapsulation layer TFE1-6 which connects the first sub-encapsulation layer TFE1-4 and the second sub-encapsulation layer TFE1-5, thereby forming the first encapsulation layer TFE1. The first encapsulation layer TFE1 may separate (i.e., space apart) the second electrodes EL2 of the first light-emitting diodes ED1 from the second electrodes EL2 of the second light-emitting diodes ED2 in the region overlapping with the opening OP in a planar view.

Referring to FIG. 19, in the step of forming a second contact hole (S250), the method may include etching the first encapsulation layer TFE1 in association with forming a first sub-contact hole CH2-1, which exposes a portion of the upper surface of the second electrode EL2 of the first light-emitting diode ED1, and a second sub-contact hole CH2-2, which exposes a portion of the upper surface of the second electrode EL2 of the second light-emitting diode ED2. Moreover, the method may include forming a third sub-contact hole (not assigned a reference numeral in the drawing) exposing a portion of the upper surface of the second electrode EL2 of the third light-emitting diode ED3.

In the step of forming a common electrode (S260), the method may include forming a common electrode CE on the first encapsulation layer TFE1. The common electrode CE may be formed using an open mask. The common electrode CE may be connected to the second electrode EL2 of the first light-emitting diode ED1 through the first sub-contact hole CH2-1, to the second electrode EL2 of the second light-emitting diode ED2 through the second sub-contact hole CH2-2, and to the second electrode EL2 of the third light-emitting diode ED3 through the third sub-contact hole. As a result, the second electrodes EL2 of the first light-emitting diode ED1, the second light-emitting diode ED2, and the third light-emitting diode ED3 may be electrically connected through the common electrode CE to receive a common voltage.

In the step of forming a second encapsulation layer (S270), the method may include forming a second encapsulation layer TFE2 on the common electrode CE. The second encapsulation layer TFE2 may include, for example, but not limited to, an organic layer, specifically a fourth sub-encapsulation layer TFE2-1, and an inorganic layer, specifically a fifth sub-encapsulation layer TFE2-2. The fourth sub-encapsulation layer TFE2-1 may be disposed between the common electrode CE and the fifth sub-encapsulation layer TFE2-2 and improve flatness.

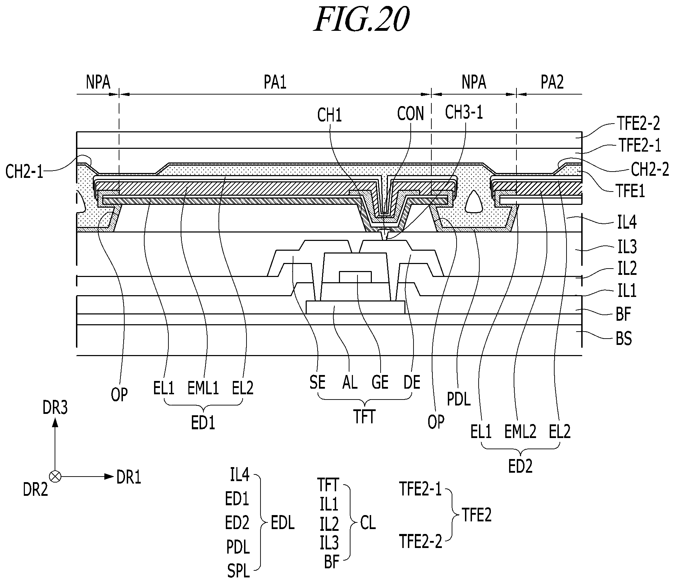

FIG. 20 illustrates a modified example of the display panel described with reference to FIGS. 1 to 6. Referring to FIG. 20, in this modified example, the first electrode EL1 may be connected to the drain electrode DE of the transistor TFT not directly but through a contact electrode CON. In such a case, the first contact hole CH1 may be disposed on the third insulating layer IL3 of the circuit layer CL. The depth of the first contact hole CH1, that is, the height from the bottom surface of the first contact hole CH1 to the upper surface of the fourth insulating layer IL4, may be reduced compared to what is illustrated in FIG. 3. As a result, even if the diameter of the first contact hole CH1 is further reduced, the step coverage of the first electrode EL1 can still be ensured. The contact electrode CON may be connected to the drain electrode DE of the transistor TFT through a third contact hole CH3-1 provided in the third insulating layer IL3 of the circuit layer CL. The upper diameter of the third contact hole CH3-1 may be smaller than the lower diameter of the first contact hole CH1. The contact electrode CON may cover the third contact hole CH3-1 in a planar view.

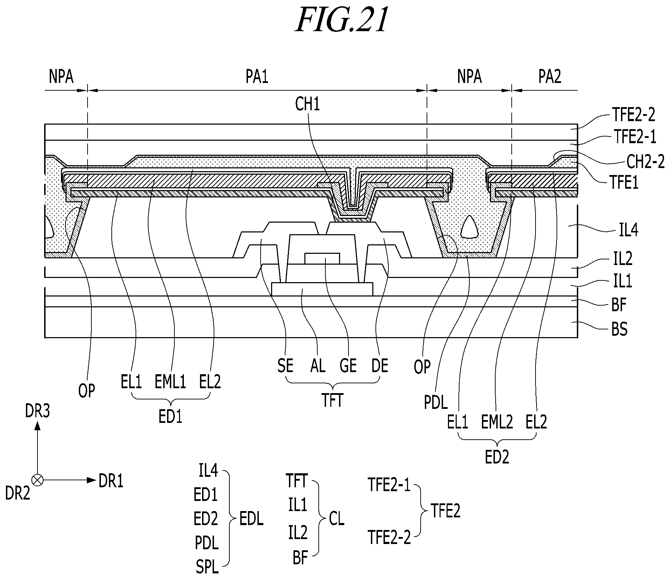

FIG. 21 illustrates another modified example of the display panel described with reference to FIGS. 1 to 6. Referring to FIG. 21, in this modified example, the third insulating layer IL3 of the circuit layer CL may be omitted, and the fourth insulating layer IL4 of the display element layer EDL may perform the function of the third insulating layer IL3. That is, the fourth insulating layer IL4 of the display element layer EDL may cover the source electrode SE and the drain electrode DE. As a result, the thickness of the display panel DP can be reduced by as much as the distance from the drain electrode DE of the transistor TFT to the upper surface of the third insulating layer IL3. Moreover, even if the diameter of the first contact hole CH1 is reduced compared to what is illustrated in FIG. 3, the step coverage of the first electrode EL1 can still be ensured.

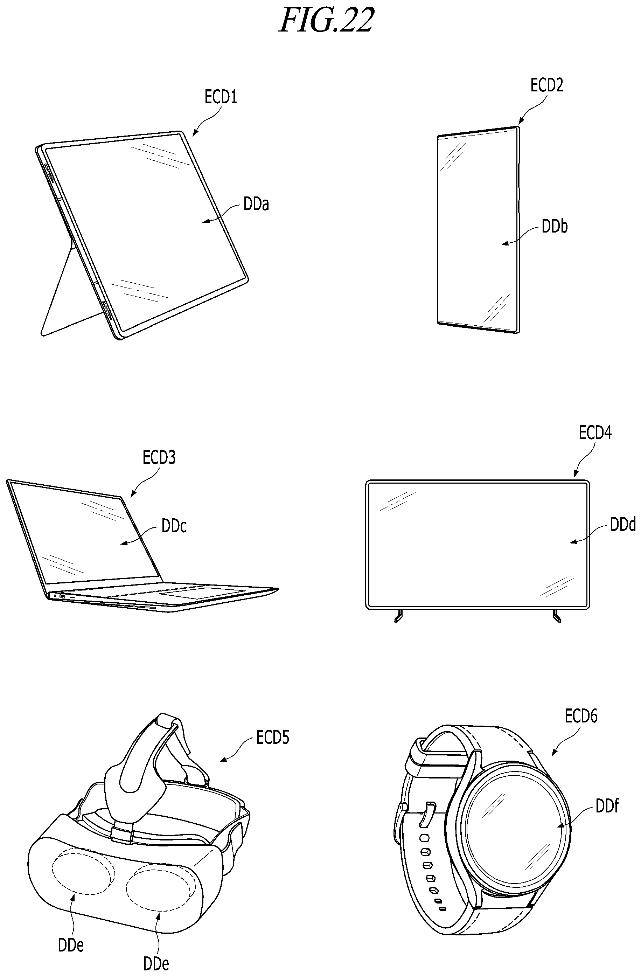

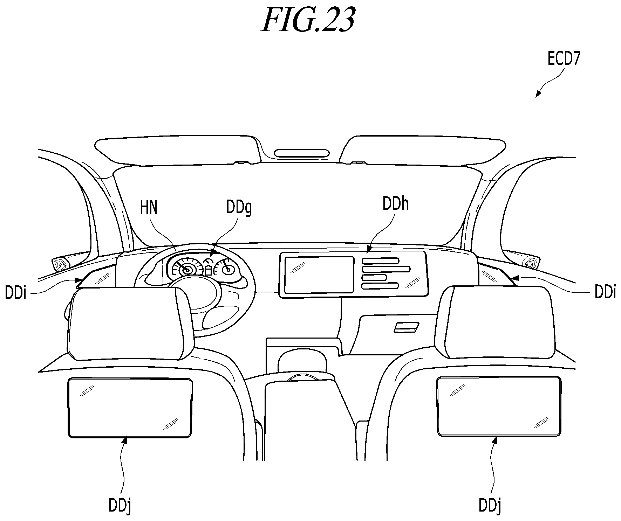

FIGS. 22 and 23 illustrate electronic devices including the display panel according to an embodiment of the present disclosure. Referring to FIG. 22, a first electronic device ECD1 is a tablet PC including a first display device DDa. A second electronic device ECD2 is a portable terminal including a second display device DDb. A third electronic device ECD3 is a laptop computer including a third display device DDc. A fourth electronic device ECD4 is a television including a fourth display device DDd. A fifth electronic device ECD5 is a head-mounted display device including a fifth display device DDe. A sixth electronic device ECD6 is a digital watch including a sixth display device DDf.

Referring to FIG. 23, a seventh electronic device ECD7 is a vehicle including seventh through tenth display devices DDg to DDj. The seventh electronic device ECD7 is illustrated as a car as an example, but the seventh electronic device ECD7 is not limited to this example and may be various types of vehicles such as, for example, bicycles, motorcycles, trains, ships, airplanes, and the like.

The seventh display device DDg may be positioned in behind of a steering wheel HN within the driver's line of sight and may be used to display dashboard information, such as, for example, the vehicle's speed. An eighth display device DDh may be disposed on the vehicle's dashboard separately from the seventh display device DDg and may be used to display information related to the vehicle's control interface, audio, temperature, road conditions, or videos. A ninth display device DDi may be disposed on the side of the driver's seat and on the side of the passenger's seat and may serve as a digital side mirror. The ninth display device DDi may display images captured outside the vehicle. A tenth display device DDj may be positioned at the back of the driver's seat and at the back of the passenger's seat and may be used to display content viewable by rear-seat passengers, such as, for example, videos.

At least one of the first through tenth display devices DDa-DDj may include the display panel DP described with reference to FIGS. 1 to 6. At least one of the first through tenth display devices DDa-DDj may also include the display panel DP described with reference to FIG. 20 or FIG. 21.

In addition to the electronic devices illustrated in FIGS. 22 and 23, the display device according to the embodiment of embodiments of the present disclosure are not limited thereto and may be applied to various electronic devices such as, for example, printers, telephones, wearable devices, digital cameras, camcorders, viewfinders, 3D displays, video walls including tiled displays, theaters, billboards, and the like.

Hitherto, the foregoing description has been presented with reference to example embodiments of the present disclosure, but these are examples and are not intended to limit the scope of the present disclosure. It should be understood by those skilled in the art that various modifications and changes can be made to the embodiments without departing from the scope of the invention as defined by the claims. Such modifications, additions, alterations, or deletions of elements are intended to be included within the scope of the present disclosure.

## Claims

1. A display panel comprising:
a substrate (BS);
a transistor (TFT) disposed on the substrate;
an insulating layer (IL4) disposed on the transistor and comprising an opening (OP);
a first light-emitting diode (ED1) and a second light-emitting diode (ED2) disposed adjacent to each other on the insulating layer (IL4); and
a first encapsulation layer disposed on the first light-emitting diode (ED1) and the second light-emitting diode (ED2),
wherein each of the first light-emitting diode (ED1) and the second light-emitting diode (ED2) comprises:
a first electrode (EL1) disposed on the insulating layer (IL4), wherein an edge portion (EL1-0) of the first electrode overlaps with the opening (OP) in a planar view;
a light-emitting layer (EML1, EML2) disposed on the first electrode (EL1); and
a second electrode (EL2) disposed on the light-emitting layer (EML1, EML2),
wherein the second electrode (EL2) of the first light-emitting diode (ED1) is spaced apart from the second electrode (EL2) of the second light-emitting diode by the first encapsulation layer (TFE1) in a region overlapping the opening (OP) in the planar view.

2. The display panel of claim 1, wherein:
a side surface of the second electrode (EL2) of the first light-emitting diode (ED1) and a side surface of the second electrode (EL2) of the second light-emitting diode (ED2) are disposed in a region overlapping with the opening (OP) in the planar view, and
the first encapsulation layer (TFE1) covers the side surface of the second electrode (EL2) of the first light-emitting diode (ED1) and the side surface of the second electrode (EL2) of the second light-emitting diode (ED2) in a cross-sectional view.

3. The display panel of claim 1 or 2, wherein:
the first encapsulation layer (TFE1) comprises:
a first portion (TFE1-1) overlapping with the second electrode (EL2) of the first light-emitting diode (ED1) in the planar view and being disposed on the second electrode (EL2) of the first light-emitting diode,
a second portion (TFE1-2) overlapping with the second electrode (EL2) of the second light-emitting diode (ED2) in the planar view and being disposed on the second electrode (EL2) of the second light-emitting diode (ED2), and
a third portion connecting the first portion and the second portion in a region overlapping with the opening in the planar view, and
the first through third portions have an integrated shape, and the third portion (TFE1-3) comprises:
a first sub-portion (TFE1-3-1) overlapping with the second electrode (EL2) of the first light-emitting diode (ED1) in the planar view and being disposed below the second electrode (EL2) of the first light-emitting diode (ED1),
a second sub-portion (TFE1-3-2) overlapping with the second electrode (EL2) of the second light-emitting diode (ED2) in the planar view and being disposed below the second electrode (EL2) of the second light-emitting diode (ED2), and
a third sub-portion (TFE1-3-3) being disposed between the second electrode (EL2) of the first light-emitting diode (ED1) and the second electrode (EL2) of the second light-emitting diode (ED2) in the planar view and connecting the first portion (TFE1-1), the second portion (TFE1-2), the first sub-portion (TFE1-3-1), and the second sub-portion (TFE1-3-2).

4. The display panel of claim 3, wherein an upper surface of the third sub-portion (TFE1-3-3) is positioned higher than the second electrode (EL2) of the first light-emitting diode (ED1) and the second electrode (EL2) of the second light-emitting diode (ED2) across an entire region between the second electrode (EL2) of the first light-emitting diode (ED1) and the second electrode (EL2) of the second light-emitting diode (ED2) in a cross-sectional view.

5. The display panel of claim 4, wherein:
the first encapsulation layer (TFE1) comprises an inorganic material, and
a cavity is between the upper surface and a lower surface of the third sub-portion (TFE1-3-3), the cavity (C) being a sealed space defined by the first encapsulation layer.

6. The display panel of claim 4 or 5, further comprising:
a common electrode (CE) disposed on the first encapsulation layer (TFE1); and
a second encapsulation layer (TFE2) disposed on the common electrode,
wherein:
the first encapsulation layer (TFE1) comprises second contact holes (CH2-1, CH2-2) respectively exposing:
a portion of an upper surface of the second electrode (EL2) of the first light-emitting diode (ED1); and
a portion of an upper surface of the second electrode (EL2) of the second light-emitting diode (ED2), and
the common electrode (CE) is respectively connected to the second electrode (EL2) of the first light-emitting diode (ED1) and the second electrode (EL2) of the second light-emitting diode (ED2) through the second contact holes (CH2-1, CH2-2).

7. The display panel of claim 6, wherein:
the second contact holes (CH2-1, CH2-2) comprise:
a first sub-contact hole (CH2-1) exposing a portion of the upper surface of the second electrode (EL2) of the first light-emitting diode (ED1); and
a second sub-contact hole (CH2-2) exposing a portion of the upper surface of the second electrode (EL2) of the second light-emitting diode (ED2),
the common electrode (CE) is connected to the second electrode (EL2) of the first light-emitting diode (ED1) through the first sub-contact hole (CH2-1),
the common electrode (CE) is connected to the second electrode (EL2) of the second light-emitting diode (ED2) through the second sub-contact hole (CH2-2), and
the common electrode (CE) has an integrated shape and connects the second electrode (EL2) of the first light-emitting diode (ED1) and the second electrode (EL2) of the second light-emitting diode (ED2) together.

8. The display panel of claim 6 or 7, wherein the second encapsulation layer comprises:
a fourth sub-encapsulation layer (TFE2-1) disposed on the common electrode (CE) and comprising an organic material; and
a fifth sub-encapsulation layer (TFE2-2) disposed on the fourth sub-encapsulation layer and comprising an inorganic material.

9. The display panel of claim 6, 7, or 8, wherein:
the second electrode (EL2) of the first light-emitting diode (ED1) comprises:
a cathode electrode (20) disposed on the light-emitting layer (EML1) of the first light-emitting diode (ED1); and
a protective electrode (21) disposed on the cathode electrode (20); and
the second electrode (EL2) of the second light-emitting diode (ED2) comprises:
a cathode electrode (20) disposed on the light-emitting layer (EML2) of the second light-emitting diode (ED2); and
a protective electrode (21) disposed on the cathode electrode (20).

10. The display panel of any one of claims 3 to 9, further comprising a pixel defining layer (PDL) surrounding an upper surface, a side surface, and a lower surface of the edge portion (EL1-0) of the first electrode (EL1) of the first light-emitting diode (ED1) and an upper surface, a side surface, and a lower surface of an edge portion (EL1-0) of the first electrode (EL1) of the second light-emitting diode (ED2),
wherein the pixel defining layer (PDL) extends along a side surface and a bottom surface of the opening (OP), has an integrated shape, and comprises an inorganic material,
wherein the pixel defining layer comprises:
a first lower portion (PDL-BS1) disposed between the lower surface of the edge portion (EL1-0) of the first electrode (EL1) of the first light-emitting diode (ED1) and an upper surface of the first sub-portion (TFE1-1) of the first encapsulation layer (TFE1);
a first side portion (PDL-SS 1) disposed between a side surface of the insulating layer (IL4) defining the opening (OP) and a side surface of the first sub-portion (TFE1-1) of the first encapsulation layer (TFE1);
a second lower portion (PDL-BS2) disposed between the lower surface of the edge portion of the first electrode (EL1) of the second light-emitting diode (ED2) and an upper surface of the second sub-portion (TFE1-2) of the first encapsulation layer;
a second side portion (PDL-SS2) disposed between a side surface of the insulating layer (IL4) defining the opening (OP) and a side surface of the second sub-portion (TFE1-2) of the first encapsulation layer; and
a bottom portion (PDL-B) disposed between the bottom surface of the opening (OP) and a lower surface of the third portion (TFE1-3) of the first encapsulation layer.

11. The display panel of claim 10, wherein:
the insulating layer (IL4) comprises a first contact hole (CH1),
the first electrode (EL1) of the first light-emitting diode (ED1) is connected to the transistor (TFT) through the first contact hole (CH1),
the first electrode (E11), the light-emitting layer (EML1), and the second electrode (EL2) of the first light-emitting diode (ED1) each cover the first contact hole (CH1) in the planar view, and
the display panel further comprises a short-circuit prevention layer (SPL) disposed between the first electrode (EL1) and the light-emitting layer (EML1) of the first light-emitting diode (ED1) and covering the first contact hole (CH1) in the planar view.

12. The display panel of claim 11, wherein:
the first electrode (EL 1) of the first light-emitting diode (ED1) comprises a first protrusion (P1) extending downward toward the transistor (TFT) in a region overlapping the first contact hole (CH1) in the planar view,
the short-circuit prevention layer (SPL) comprises a second protrusion (P2) extending downward toward the transistor (TFT) in a region overlapping the first contact hole (CH1) in the planar view, the second protrusion (P2) being disposed within the first protrusion (P1),
the light-emitting layer (EML1) of the first light-emitting diode (ED1) comprises a third protrusion (P3) extending downward toward the transistor (TFT) in a region overlapping the first contact hole (CH1) in the planar view, the third protrusion being disposed within the second protrusion (P2), and
the second electrode (EL2) of the first light-emitting diode (ED1) comprises a fourth protrusion (P4) extending downward toward the transistor (TFT) in a region overlapping the first contact hole (CH1) in the planar view, the fourth protrusion being disposed within the third protrusion (P3).

13. The display panel of claim 11 or 12, wherein the short-circuit prevention layer (SPL) is formed of a same material as the pixel defining layer (PDL).

14. The display panel of claim 11, 12, or 13, wherein the first electrode (EL1) of the first light-emitting diode (ED1) comprises:
a metal layer (11) disposed on the insulating layer (IL4) ; and
an anode electrode (10) disposed between the metal layer and the light-emitting layer (EML1) of the first light-emitting diode (ED1).

15. The display panel of any one of claims 1 to 14, wherein:
the light-emitting layer (EML1) of the first light-emitting diode (ED1) covers the first electrode (EL1) of the first light-emitting diode (ED1) in the planar view, and
at least a portion of the light-emitting layer (EML1) of the first light-emitting diode (ED1) is disposed on a side surface of the first electrode (EL1) of the first light-emitting diode (ED1).
